(19) **Europäisches Patentamt**
**European Patent Office**
**Office européen des brevets**

(11) **EP 4 786 636 A1**

(12) **EUROPEAN PATENT APPLICATION**

(43) Date of publication:
**05.08.2026 Bulletin 2026/32**

(21) Application number: **26153718.7**

(22) Date of filing: **23.01.2026**

(51) International Patent Classification (IPC):
**C23C 16/455** (2006.01)    **C23C 16/458** (2006.01)
**C23C 16/52** (2006.01)

(52) Cooperative Patent Classification (CPC):
**C23C 16/45504; C23C 16/45546; C23C 16/45578; C23C 16/4584; C23C 16/52**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **29.01.2025 JP 2025013309**

(71) Applicant: **Kokusai Electric Corporation
Tokyo 101-0045 (JP)**

(72) Inventors:
• **MORI, Hiroki**
  **Toyama-shi, Toyama, 939-2393 (JP)**
• **NAKANO, Hikari**
  **Toyama-shi, Toyama, 939-2393 (JP)**

(74) Representative: **Bardehle Pagenberg
Partnerschaft mbB
Patentanwälte Rechtsanwälte
Prinzregentenplatz 7
81675 München (DE)**

(54) **METHOD OF DETERMINING ROTATIONAL SPEED, METHOD OF PROCESSING SUBSTRATE, METHOD OF MANUFACTURING SEMICONDUCTOR DEVICE, PROGRAM, AND SUBSTRATE PROCESSING APPARATUS**

(57) A technique of determining a rotational speed of a substrate (200), applied in a substrate processing including intermittently supplying, to the rotating substrate (200), a process gas from an outer edge of the substrate (200) toward an in-plane direction at a constant interval, a predetermined number of times K, during a predetermined duration T, includes: (a) calculating an evaluation value E corresponding to each of a plurality of candidate values N, which are candidate values for the selectable rotational speed of the substrate (200), based on: at least one selected from the group of the predetermined duration T and a supply interval I of the process gas; the predetermined number of times K; and each of the candidate values N; and (b) determining the rotational speed of the substrate (200) to be applied in the substrate processing from among the candidate values N based on the evaluation value E calculated for each candidate value N.

FIG. 8

EP 4 786 636 A1

**Description**

CROSS-REFERENCE TO RELATED APPLICATION

This application is based upon and claims the benefit of priority from Japanese Patent Application No. 2025-013309, filed on January 29, 2025, the entire contents of which are incorporated herein by reference.

TECHNICAL FIELD

The present disclosure relates to a method of determining a rotational speed, a method of processing a substrate, a method of manufacturing a semiconductor device, a program, and a substrate processing apparatus.

BACKGROUND

In related technologies, as one of semiconductor device manufacturing processes, processing on a substrate may be performed by repeatedly supplying a gas to the rotating substrate.

SUMMARY

The present disclosure provides a technique capable of improving in-plane uniformity of processing on a rotating substrate.
According to embodiments of the present disclosure, there is provided a technique that includes determining a rotational speed of a substrate, applied in a substrate processing including intermittently supplying, to the rotating substrate, a process gas from an outer edge of the substrate toward an in-plane direction at a constant interval, a predetermined number of times K, during a predetermined duration T, the determining the rotational speed of the substrate including (a) calculating an evaluation value E corresponding to each of a plurality of candidate values N, which are a plurality of candidate values for the selectable rotational speed of the substrate, based on: at least one selected from the group of the predetermined duration T and a supply interval I of the process gas; the predetermined number of times K; and each of the plurality of candidate values N; and (b) determining the rotational speed of the substrate to be applied in the substrate processing from among the plurality of candidate values N based on the evaluation value E calculated for each of the plurality of candidate values N.

BRIEF DESCRIPTION OF DRAWINGS

The accompanying drawings, which are incorporated in and constitute a part of the specification, illustrate embodiments of the present disclosure.

FIG. 1 is a schematic configuration diagram of a vertical process furnace of a substrate processing apparatus suitably used in an embodiment of the present disclosure, illustrating a portion of the process furnace in a longitudinal cross-sectional view.
FIG. 2 is a schematic configuration diagram of the vertical process furnace of the substrate processing apparatus suitably used in the embodiment of the present disclosure, illustrating a portion of the process furnace in a cross-sectional view taken along line A-A of FIG. 1.
FIG. 3 is a schematic configuration diagram of a controller of the substrate processing apparatus suitably used in the embodiment of the present disclosure, illustrating a control system of the controller in a block diagram.
FIG. 4 is a diagram illustrating a processing sequence in the embodiment of the present disclosure.
FIGS. 5A and 5B are diagrams illustrating a supply start position of a process gas for each cycle during a predetermined duration.
FIGS. 6A to 6C are diagrams illustrating a minimax arrangement method suitably used in the embodiment of the present disclosure.

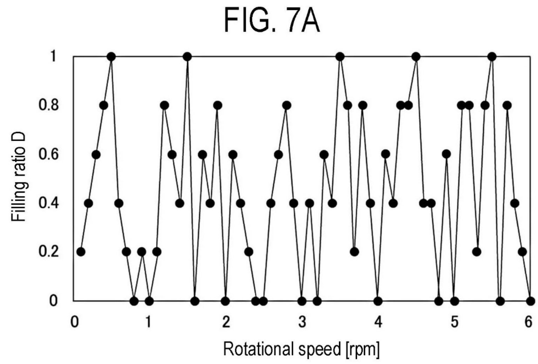

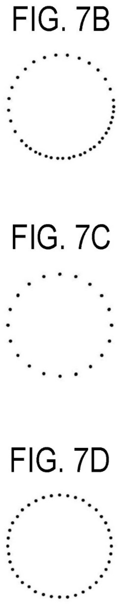

FIG. 7A is a diagram illustrating calculation results when the minimax arrangement method suitably used in the embodiment of the present disclosure is applied. FIG. 7B is a diagram illustrating a distribution of the supply start position of the process gas for each cycle when a rotational speed is 0.2 rpm. FIG. 7C is a diagram illustrating a distribution of the supply start position of the process gas for each cycle when the rotational speed is 4 rpm. FIG. 7D is a diagram illustrating a distribution of the supply start position of the process gas for each cycle when the rotational speed is 4.5 rpm.
FIG. 8 is a diagram illustrating an example of a display screen displayed on a display of the present disclosure.
FIG. 9 is a diagram illustrating a potential energy suitably used in another embodiment of the present disclosure.

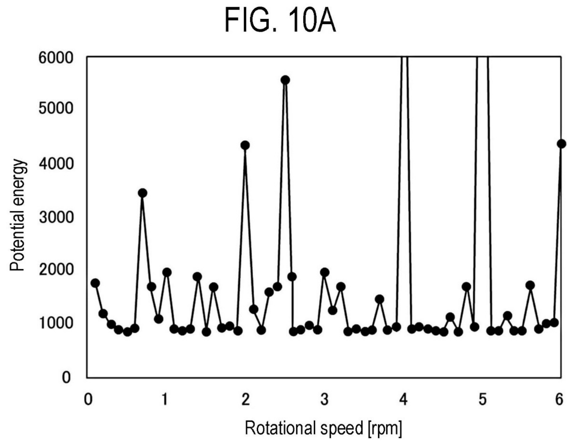

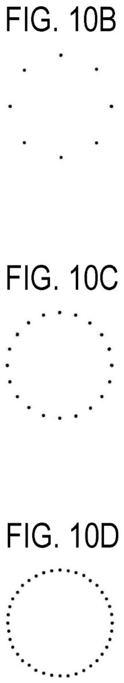

FIG. 10A is a diagram illustrating calculation results when a minimum energy arrangement method suitably used in the another embodiment of the present disclosure is applied. FIG. 10B is a diagram illustrating a distribution of the supply start position of the process gas for each cycle when the rotational speed is 2.5 rpm. FIG. 10C is a diagram illustrating a distribution of the supply start position of the process gas for each cycle when the rotational speed is 3 rpm. FIG. 10D is a diagram illustrating a distribution of the supply start position of the process gas for each cycle when the rotational speed is 4.5 rpm.

DETAILED DESCRIPTION

Reference will now be made in detail to various embodiments, examples of which are illustrated in the accompanying drawings. In the following detailed description, numerous specific details are set forth to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

<Embodiments of Present Disclosure>

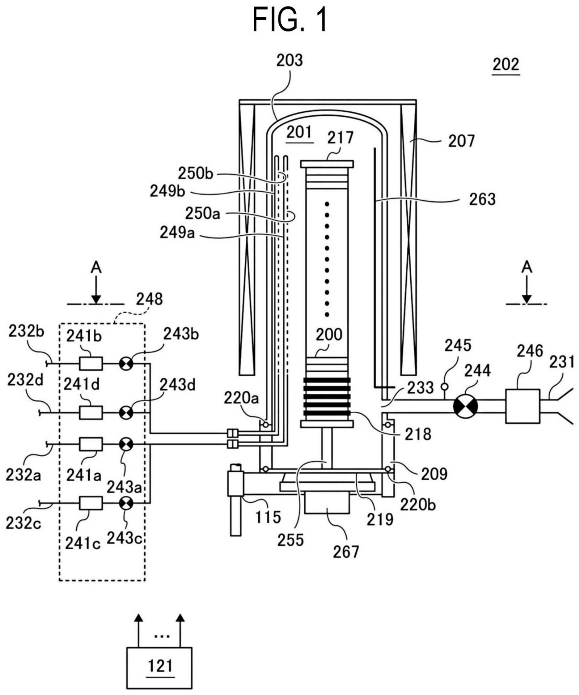

Hereinafter, embodiments of the present disclosure are described mainly with reference to FIGS. 1 to 10D. In addition, the drawings used in the following description are schematic, and dimensional relationships between respective components, proportions of respective components, and the like illustrated in the drawings may not correspond to those in reality. Further, the dimensional relationships between respective components, proportions of respective components may not match among multiple drawings.

(1) Configuration of Substrate Processing Apparatus

As illustrated in FIG. 1, a process furnace 202 includes a heater 207 serving as a temperature regulator (heating part). A reaction tube 203 is disposed concentrically with the heater 207 inside the heater 207. A manifold 209 is disposed concentrically with the reaction tube 203 below the reaction tube 203. An O-ring 220a is formed as a seal between the manifold 209 and the reaction tube 203. A process container (reaction container) mainly includes the reaction tube 203 and the manifold 209. A process chamber 201 is formed in a cylindrical hollow region of the process container. The process chamber 201 is configured to be capable of accommodating wafers 200 serving as substrates. The wafer 200 is processed inside the process chamber 201.

Nozzles 249a and 249b are provided as a first supplier and a second supplier inside the process chamber 201 so as to penetrate a sidewall of the manifold 209, respectively. The nozzles 249a and 249b are also referred to as a first nozzle and a second nozzle, respectively. Gas supply pipes 232a and 232b are respectively connected to the nozzles 249a and 249b. The nozzles 249a and 249b are different nozzles, and are provided adjacent to each other.

The gas supply pipes 232a and 232b are installed, respectively, with mass flow controllers (MFCs) 241a and 241b, which serve as flow rate controllers (flow rate control parts), and valves 243a and 243b, which serve as opening/closing valves, in order from an upstream side of a gas flow. A gas supply pipe 232c is connected to the gas supply pipe 232a at a downstream side of the valve 243a. A gas supply pipe 232d is connected to the gas supply pipe 232b at a downstream side of the valve 243b. The gas supply pipes 232c and 232d are installed, respectively, with MFCs 241c and 241d and valves 243c and 243d in order from an upstream side of gas flow.

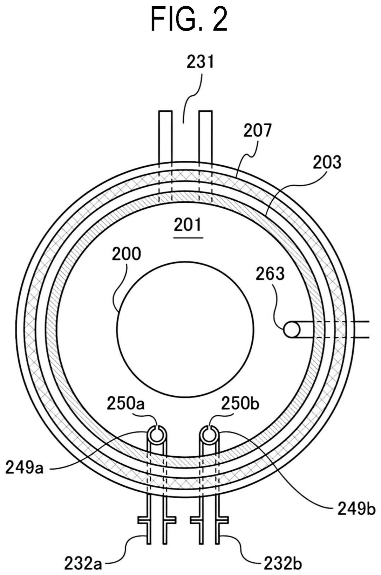

As illustrated in FIG. 2, the nozzles 249a and 249b are installed in a space, formed in an annular shape in a plane view, between an inner wall of the reaction tube 203 and the wafers 200, so as to respectively extend upward in an arrangement direction of the wafers 200 from a lower portion to an upper portion of the inner wall of the reaction tube 203. That is, the nozzles 249a and 249b are installed in a region horizontally surrounding a wafer arrangement region, in which the wafers 200 are arranged, at a lateral side of the wafer arrangement region, so as to extend along the wafer arrangement region. Gas supply holes 250a and 250b, which serve as supply ports for supplying gases, are formed at side surfaces of the nozzles 249a and 249b respectively. A plurality of gas supply holes 250a and 250b are provided from a lower portion to an upper portion of the reaction tube 203.

A first gas, which serves as a process gas, is supplied from the gas supply pipe 232a into the process chamber 201 through the MFC 241a, valve 243a, and nozzle 249a. The first gas may also be referred to as a precursor gas.

A second gas, which serves as a process gas different from the first gas, is supplied from the gas supply pipe 232b into the process chamber 201 through the MFC 241b, valve 243b, and nozzle 249b. The second gas may also be referred to as a reaction gas that reacts with the first gas.

An inert gas, which serves as a process gas, is supplied from the gas supply pipes 232c and 232d into the process chamber 201 through the MFCs 241c and 241d, valves 243c and 243d, gas supply pipes 232a and 232b, and nozzles 249a and 249b. The inert gas acts, for example, as a purge gas, a carrier gas, and a dilution gas.

A first gas supply system mainly includes the gas supply pipe 232a, MFC 241a, and valve 243a. A second gas supply system mainly includes the gas supply pipe 232b, MFC 241b, and valve 243b. The first gas supply system may also be referred to as a precursor gas supply system. Further, the second gas supply system may also be referred to as a reaction gas supply system. An inert gas supply system mainly includes the gas supply pipes 232c and 232d, MFCs 241c and 241d, and valves 243c and 243d. A gas supply system is constituted by the entire or at least one selected from the group of the above-described various supply systems. The nozzles connected to the gas supply pipes constituting the above-described various supply systems may each be included in the corresponding supply system.

Any of or the entire above-described various supply systems may be configured as an integrated supply system 248 in which the valves 243a to 243d, MFCs 241a to 241d, and others are integrated.

An exhaust port 233 for exhausting an internal atmosphere of the process chamber 201 is installed below a sidewall of the reaction tube 203. An exhaust pipe 231 is connected to the exhaust port 233. The exhaust pipe 231 is connected to a vacuum pump 246, which serves as a vacuum exhauster, via a pressure sensor 245, which serves as a pressure detector (pressure detection part) that detects an internal pressure of the process chamber 201, and via an auto pressure controller (APC) valve 244, which serves as a pressure regulator (pressure regulating part). The APC valve 244 is configured to perform or stop vacuum-exhaust inside the process chamber 201 by opening or closing the valve while the vacuum pump 246 is in operation. The APC valve 244 is also configured to regulate the internal pressure of the process chamber 201 by adjusting a valve opening degree based on pressure information detected by the pressure sensor 245 while the vacuum pump 246 is in operation. An exhaust system mainly includes the exhaust pipe 231, APC valve 244, and pressure sensor 245. The vacuum pump 246 may also be considered as included in the exhaust system.

A seal cap 219 is installed below the manifold 209 and serves as a furnace opening lid capable of airtightly closing an opening at a lower end of the manifold 209 via an O-ring 220b. A rotator 267, which serves as a rotation driver, is installed below the seal cap 219 to rotate a boat 217 to be described later. A rotating shaft 255 of the rotator 267 passes through the seal cap 219 and is connected to the boat 217. The rotator 267 is configured to rotate the wafer 200 by rotating the boat 217. The seal cap 219 is configured to be vertically raised or lowered by a boat elevator 115, which serves as a lift installed outside the reaction tube 203.

The boat 217, which serves as a substrate support, is configured to support a plurality of wafers 200, e.g., "25 to 200" wafers in such a state that the wafers 200 are arranged in a horizontal posture and in multiple stages in a vertical direction with centers of the wafers 200 aligned with one another, i.e., to arrange the wafers 200 at intervals. Thermal insulation plates 218 are supported in multiple stages at a lower portion of the boat 217.

A temperature sensor 263 serving as a temperature detector is installed inside the reaction tube 203. An internal temperature of the process chamber 201 becomes a desired temperature distribution by regulating a state of supplying electric power to the heater 207 based on temperature information detected by the temperature sensor 263.

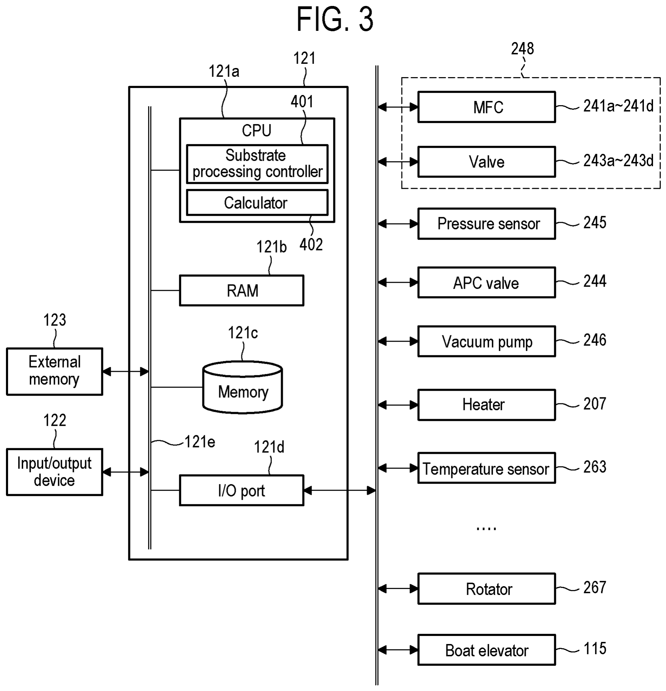

As illustrated in FIG. 3, a controller 121, which serves as a control part (control means), is configured as a computer including a central processing unit (CPU) 121a, a random access memory (RAM) 121b, a memory 121c, and an I/O port 121d. The RAM 121b, memory 121c, and I/O port 121d are configured to be capable of exchanging data with the CPU 121a via an internal bus 121e. The controller 121 is connected to an input/output device 122, which serves as an input part and an output part and is configured as, for example, a touch panel or the like. The input/output device 122 may constitute a display. Further, the controller 121 is configured to enable connection with an external memory 123. In addition, a substrate processing apparatus may be configured to include a single controller, or may be configured to include a plurality of controllers. In other words, control for performing a processing sequence to be described later may be performed using a single controller, or may be performed using a plurality of controllers. Further, the plurality of controllers may be configured as a control system by being connected to each other via a wired or wireless communication network, and the control for performing the processing sequence to be described later may be performed by the entire control system. When the term "controller" is used in the present disclosure, it may refer to a case of including a single controller, a case of including a plurality of controllers, or a case of including a control system configured by a plurality of controllers.

The memory 121c is configured with, for example, a flash memory, a hard disk drive (HDD), a solid state drive (SSD), or a similar one. The memory 121c records and stores, in a readable manner, a control program for controlling an operation of the substrate processing apparatus, a process recipe containing, e.g., substrate processing procedures and conditions to be described later, and others. The process recipe is a combination that causes the controller 121 to execute each procedure for a substrate processing to be described later in the substrate processing apparatus to obtain predetermined results. The process recipe functions as a program. Hereinafter, the process recipe, control program, and others are collectively referred to simply as programs (program products). Further, the process recipe is also simply referred to as a recipe. When the term "program" is used in the present disclosure, it may refer to a case of solely including the recipe, a case of solely including the control program, or a case of including both. The RAM 121b is configured as a memory area (work area) where programs and data read by the CPU 121a, data input from an operator through the input/output device 122, and others are temporarily stored. A memory is configured by at least one selected from the group of the memory 121c and the RAM 121b.

The I/O port 121d is connected to the above-described MFCs 241a to 241d, valves 243a to 243d, pressure sensor 245, APC valve 244, vacuum pump 246, temperature sensor 263, heater 207, temperature sensor 263, rotator 267, boat elevator 115, and others.

The CPU 121a is configured to be capable of reading and executing the control program from the memory 121c, as well as reading the recipe from the memory 121c in response to an input of an operation command and the like from the input/output device 122. The CPU 121a includes a substrate processing controller 401 and a calculator 402.

The substrate processing controller 401 is configured to be capable of controlling, in accordance with contents of a read recipe, a flow rate regulating operations of various process gases by the MFCs 241a to 241d, opening/closing operations of the valves 243a to 243d, a pressure regulating operation by the APC valve 244 based on the pressure sensor 245 as well as an opening/closing operation of the APC valve 244, startup and shutdown of the vacuum pump 246, a temperature regulating operation of the heater 207 based on the temperature sensor 263, operations of rotating and adjusting a rotational speed of the boat 217 by the rotator 267, a raising/lowering operation of the boat 217 by the boat elevator 115, and others.

For example, the substrate processing controller 401 is configured to be capable of controlling the rotator 267, MFCs 241a to 241d, valves 243a to 243d, and others such that process gases such as the first gas, the second gas, and the inert gas are intermittently supplied to the wafer 200 at constant intervals, a predetermined number of times K, during a predetermined duration T while the wafer 200 is rotated at a constant rotational speed.

The memory 121c, which serves as a memory, stores a set value of at least one selected from the group of a process time (predetermined duration) T, which is an execution time of a substrate processing process to be described later, and a cycle time I, which is a time per cycle (also referred to as a supply interval), a set value of a cycle count (predetermined number of times) K, a minimum width (also referred to as an increment or a resolution) in which the rotational speed is changeable, upper and lower limits of the rotational speed, and others. The cycle time may be calculated and expressed as T/K based on the process time T and the cycle count K. Further, the process time T may be calculated and expressed as I*K based on the cycle time I and the cycle count K.

The calculator 402 calculates an evaluation value corresponding to each of a plurality of candidate values for the selectable rotational speed of the rotator 267 based on: at least one selected from the group of the process time T and the cycle time I; the cycle count K, and the respective candidate values, as is described later in detail. The calculator 402 is configured to calculate the plurality of candidate values for the selectable rotational speed respectively based on the minimum width stored in the memory 121c.

Then, the substrate processing controller 401 is configured to be capable of rotating the wafer 200 at a rotational speed determined from among the plurality of candidate values based on the respective evaluation values calculated by the calculator 402.

The controller 121 may be configured by installing the aforementioned program recorded and stored in the external memory 123 onto a computer. The external memory 123 includes, for example, a magnetic disk such as a HDD, an optical disk such as a CD, a magneto-optical disk such as a MO, a semiconductor memory such as an USB memory or SSD, and others. The memory 121c or the external memory 123 is configured as a computer-readable recording medium. Hereinafter, these are collectively referred to simply as the recording medium. When the term "recording medium" is used in the present disclosure, it may refer to a case of solely including the memory 121c, a case of solely including the external memory 123, or a case of including both. In addition, the program may be provided to a computer not by using the external memory 123 but via a communication means such as the Internet or a dedicated line.

(2) Substrate Processing Process

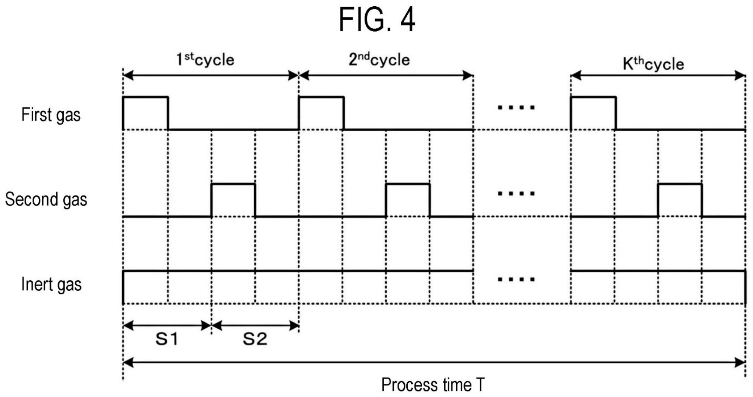

As one of semiconductor device manufacturing processes, an example of a processing sequence of processing the wafer 200 serving as a substrate by using the above-described substrate processing apparatus is described mainly with reference to FIG. 4. In the following description, an operation of each part constituting the substrate processing apparatus is controlled by the controller 121.

When the term "wafer" is used in the present disclosure, it may refer to a wafer itself, or may refer to a stack including a wafer and a predetermined layer or film formed on a surface of the wafer. When the term "surface of a wafer" is used in the present disclosure, it may refer to a surface of a wafer itself, or a surface of a predetermined layer or the like formed on a wafer. When it is stated in the present disclosure that "a predetermined layer is formed on a wafer," it may refer to a case where a predetermined layer is directly formed on a surface of a wafer itself, or a case where a predetermined layer is formed on a layer formed on a wafer. The term "substrate" used in the present disclosure is synonymous with the term "wafer."

(Wafer Charge and Boat Loading)

When a plurality of wafers 200 are charged into the boat 217, the boat 217 supporting the plurality of wafers 200 is lifted by the boat elevator 115 and is loaded into the process chamber 201.

(Pressure Regulation and Temperature Regulation)

After the boat loading is completed, an interior of the process chamber 201, i.e., a process space in which the wafers 200 are present, is vacuum-exhausted by the vacuum pump 246 to reach a desired pressure. Further, the wafers 200 inside the process chamber 201 are heated to a desired processing temperature by the heater 207. In addition, the rotation of the wafers 200 by the rotator 267 is initiated at a predetermined rotational speed determined in a step to be described later. The vacuum-exhaust of the interior of the process chamber 201 and the heating and rotation of the wafers 200 are continuously performed at least until the wafers 200 are completely processed.

Thereafter, steps S1 and S2 are sequentially executed.

[Step S1]

In step S1, the first gas is supplied to the wafer 200 inside the process chamber 201.

Specifically, the valve 243a is opened to flow the first gas into the gas supply pipe 232a. The first gas is regulated in flow rate by the MFC 241a, is supplied into the process chamber 201 through the nozzle 249a, and is exhausted from the exhaust port 233. At this time, the first gas is supplied to the wafer 200. At this time, the valves 243c and 243d may be opened so that an inert gas is supplied into the process chamber 201 through the respective nozzles 249a and 249b.

Further, in the present disclosure, a processing temperature refers to the temperature of the wafer 200 or the internal temperature of the process chamber 201, and a processing pressure refers to the internal pressure of the process chamber 201, i.e., a pressure of the space in which the wafer 200 is present. Further, a processing time refers to a time during which that processing is continued. These similarly apply to the following description.

By supplying the first gas to the wafer 200, a first layer is formed on a surface of the wafer 200.

After the first layer is formed, the valve 243a is closed to stop the supply of the first gas into the process chamber 201. Then, the interior of the process chamber 201 is vacuum-exhausted to remove gases and others remaining inside the process chamber 201 from the interior of the process chamber 201 (purge). At this time, the valves 243c and 243d are opened to supply an inert gas into the process chamber 201 through the nozzles 249a and 249b. The inert gas acts as a purge gas.

[Step S2]

After step S1 is completed, the second gas is supplied to the wafer 200 inside the process chamber 201, i.e., to the first layer formed on the wafer 200.

Specifically, the valve 243b is opened to flow the second gas into the gas supply pipe 232b. The second gas is regulated in flow rate by the MFC 241b, is supplied into the process chamber 201 through the nozzle 249b, and is exhausted from the exhaust port 233. At this time, the second gas is supplied to the wafer 200. At this time, the valves 243c and 243d may be opened to supply an inert gas into the process chamber 201 through the respective nozzles 249a and 249b.

By supplying the second gas to the wafer 200, at least a portion of the first layer formed on the wafer 200 is modified to form a second layer.

After the second layer is formed, the valve 243b is closed to stop the supply of the second gas into the process chamber 201. Then, gases and others remaining inside the process chamber 201 are removed from the interior of the process chamber 201 according to the same processing procedure as the purge in step S1.

[Execution for Predetermined Number of Times]

By performing a cycle a predetermined number of times (K times, where K is 1 or an integer of 2 or more), the cycle performing the above-described steps S1 and S2 non-simultaneously, that is, without synchronization, and intermittently (also referred to as pulsively), a predetermined layer may be formed on the surface of the wafer 200. It is desirable to perform the above-described cycle multiple times. In other words, a thickness of a predetermined layer formed per cycle is set to be thinner than a desired film thickness, and it is desirable to perform the above-described cycle multiple times until a film thickness of a predetermined layer, formed by stacking predetermined layers, reaches the desired film thickness.

(After-Purge and Atmospheric Pressure Recovery)

After steps S1 and S2 are performed the predetermined number of times, an inert gas serving as a purge gas is supplied into the process chamber 201 from the respective nozzles 249a to 249b, and is exhausted from the exhaust port 233. Thereafter, the internal atmosphere of the process chamber 201 is replaced with the inert gas, and the internal pressure of the process chamber 201 is returned to atmospheric pressure.

(Boat Unloading and Wafer Discharge)

Thereafter, the seal cap 219 is lowered by the boat elevator 115 to open the lower end of the manifold 209. Then, the processed wafer 200 is unloaded to an outside of the reaction tube 203 from the lower end of the manifold 209 while being supported by the boat 217. The processed wafer 200 is taken out from the boat 217 after being unloaded to the outside of the reaction tube 203.

(3) Determination of Rotational Speed

Next, a method of determining a rotational speed of the rotator 267 that rotates the wafer 200, which is applied in the above-described substrate processing process, is described below.

In the above-described substrate processing process, with respect to the wafer 200 rotating at a constant rotational speed, the process gas is intermittently (also referred to as pulsively) supplied from an outer edge of the wafer 200 toward an in-plane direction at a constant interval, the predetermined number of times K, during the predetermined duration T. Herein, the predetermined duration T is a process time from a start of step S1 in a first cycle of the substrate processing process to an end of step S2 in a $K^{th}$ cycle. Further, the predetermined number of times K is the number of times (also referred to as the number of processing times or the cycle count) that steps S1 and S2, which are a plurality of steps, are performed as one cycle during the predetermined duration T. In addition, one cycle is not limited to a case where a plurality of steps for supplying different gases are included in combination as in the present embodiments. For example, one cycle may include a combination of a step for supplying a single gas and a step for stopping the supply of that gas.

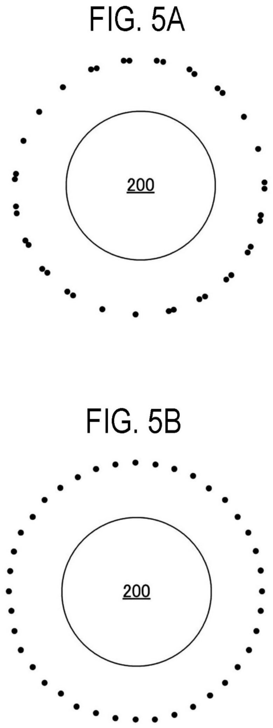

FIGS. 5A and 5B illustrate examples of a supply start position of the first gas at a point in time when the supply of the first gas for each cycle is initiated with respect to the wafer 200, in a case where, with respect to the rotating wafer 200, the process gas is intermittently supplied at a constant interval from the outer edge of the wafer 200 toward the in-plane direction by the above-described substrate processing process using the above-described substrate processing apparatus.

In the case where, with respect to the rotating wafer 200, the process gas is intermittently supplied at a constant interval from the outer edge of the wafer 200 toward the in-plane direction, the supply start positions of the process gas may overlap when a supply period of the process gas for each cycle (i.e., the cycle time I) and a rotational period of the wafer 200 (i.e., a time during which the wafer 200 makes one rotation) are synchronized during the process time T. For example, this occurs in a case where a timing at which an integer multiple of the supply period coincides with the rotational period arises during the process time T. Further, even in a case where the supply period of the process gas for each cycle and the rotational period of the wafer 200 are not synchronized during the process time T, a distribution of the supply start positions of the process gas may be biased depending on a relationship between the supply period and the rotational period, as illustrated in FIG. 5A. In such a case, non-uniformity in film thickness and film quality of films formed on the wafer 200 arises, resulting in deterioration of in-plane uniformity. In contrast, in a case where the supply period of the process gas for each cycle and the rotational period are appropriately selected, the supply start positions of the process gas do not overlap and may be uniformly dispersed, as illustrated in FIG. 5B. By achieving uniform arrangement in this way, the film thickness and film quality of films formed on the wafer 200 become uniform, resulting in improved in-plane uniformity.

Accordingly, to uniformly dispose the supply start positions of the process gas when supplying the process gas at a desired supply period, for example, a method may be adopted, in which one or a plurality of ideal rotational periods (rotational speeds) are calculated based on the desired supply period.

However, since a resolution of a motor that rotates the rotator 267 is limited, there is a case where the calculated ideal rotational speed is difficult to realize in the actual rotator. For example, there is a limit to a minimum width (also referred to as an increment or a resolution) that divides the rotation of the motor by 1 pulse. Further, upper and lower limits exist for the rotational speed of the rotator 267, and a rotational speed may not be realized due to mechanical constraints. Further, the rotational speed may be limited depending on a substrate processing condition.

Herein, the rotational speed N may be expressed as follows, using the process time T, the cycle count K, and the supply start position $P_k$ of the process gas at the start of the $k^{th}$ cycle (in the present embodiments, the supply start position of the first gas in the $k^{th}$ cycle).

[Equation 1]

$$(K, N, T) \longmapsto \{P_1, P_2, \cdots, P_k, \cdots P_K\}$$

The positions $P_1, P_2, \cdots, P_k, ..., P_k$ are points on a circumference that are to be disposed uniformly as illustrated in FIG. 5B. That is, when there exists a function $F(P_1, P_2, \cdots, P_k, ..., P_K)$ that represents uniformity or bias of the arrangement, a rotational speed within a range that maximizes or minimizes the value of the function F may be calculated.

In the present embodiments, a plurality of candidate values N ($N_1, N_2, \cdots, N_M$) for the selectable rotational speed are set based on a resolution of the rotator 267. Herein, M is the number of candidate values N (i.e., a candidate count). Then, a rotational speed at which a distribution of the supply start positions of the process gas is dispersed without overlapping, resulting in uniform arrangement as illustrated in FIG. 5B, is determined based on: the M candidate values N that the rotational speed may take; at least one selected from the group of the process time T and the cycle time I; and the cycle count K. Herein, a case is described, where an evaluation value E for determining the rotational speed is calculated based on the concept of minimax arrangement.

(3-1) Calculation of Evaluation Value E for Candidate Value N

First, a plurality of candidate values $N(N_1, N_2, \cdots, N_M)$ for the selectable rotational speed are set based on the resolution of the rotator 267. Each of the plurality of candidate values N is a value of the rotational speed that satisfies a condition (i.e., constraint) of a minimum width $N_{int}$ (also referred to as an increment or a resolution) in which the rotational speed is changeable. Further, each of the plurality of candidate values N may be selected from a range of values that are equal to or less than an upper limit value $N_{max}$ of the selectable rotational speed (that is, the candidate value $N_M$ = the upper limit value $N_{max}$). The upper limit value $N_{max}$ may be determined, for example, by a mechanical constraint of the rotator 267, or may be set such that positional displacement or dropping of the wafer 200 does not occur in the boat 217 when the wafer 200 rotates. Further, each of the plurality of candidate values N may be selected from a range of values that are equal to or greater than a lower limit value $N_{min}$ of the selectable rotational speed (that is, the candidate value $N_1$ = the lower limit value $N_{min}$). The lower limit value $N_{min}$ may be set to the same value as, for example, the minimum width $N_{int}$, or may be set to a value larger than the minimum width $N_{int}$ depending on a substrate processing condition. That is, the minimum width $N_{int}$, the upper limit value $N_{max}$, and the lower limit value $N_{min}$ are conditions for a settable rotational speed in the rotator 267 that rotates the wafer 200 (i.e., the boat 217 supporting the wafer 200).

Then, evaluation values E($E_1, E_2, ..., E_M$) corresponding respectively to the plurality of candidate values N($N_1, N_2, \cdots, N_M$) are calculated respectively based on: at least one selected from the group of the process time T and the cycle time I; the cycle count K; and the respective candidate values N. For example, the evaluation value $E_1$ corresponds to $N_1$, and the evaluation value $E_M$ corresponds to $N_M$. The evaluation value E is calculated by the calculator 402 based on information stored in the memory 121c and/or the RAM 121b (e.g., the process time T and/or the cycle time I, the cycle count K, the lower limit value $N_{min}$ and/or the minimum width $Ni_nt$, the upper limit value $N_{max}$, and others).

Herein, the evaluation values E($E_1, E_2, \cdots, E_M$) are values indicating a degree of uniformity of spacings among the positions $P_1, P_2, \cdots, P_k, ..., P_K$ on the outer edge of the wafer 200 facing the gas supply hole 250a of the first gas at a point in time when the supply of the first gas for each cycle is initiated. The number of positions P is the same as the predetermined number of times K.

(3-2) Determination of Rotational Speed based on Evaluation Value E

Then, the rotational speed of the wafer 200 to be applied in a substrate processing is determined from among the plurality of candidate values N based on the calculated evaluation value E. In the present embodiments, the rotational speed is determined based on the evaluation value E calculated for each candidate value N of the rotational speed. In the present embodiments, since, regardless of constraints such as a constraint in the resolution due to hard specifications of the rotator 267, an optimal rotational speed may be selected based on the evaluation value E from among a group of candidate values of the selectable rotational speed in which such constraints are already taken into account, the optimal rotational speed may be determined easily and efficiently.

The determination of the rotational speed based on the evaluation value E is performed by the calculator 402 according to the following procedure described below. Further, as described later, the determination may also be performed by the operator based on information derived from the evaluation value E displayed on an output screen 302. Further, the rotational speed of the wafer 200 determined in that step is acquired by the substrate processing controller 401 and is set as the rotational speed of the rotator 267.

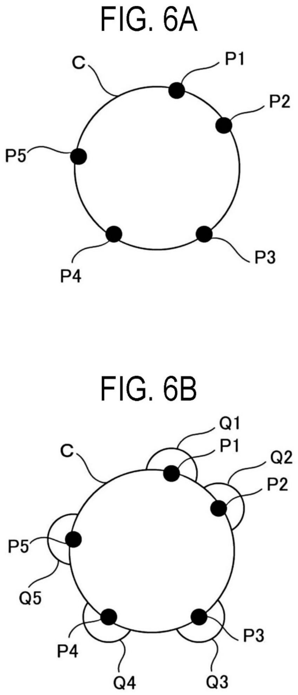

FIGS. 6A to 6C are diagrams illustrating a minimax arrangement method used when determining the above-described evaluation value E. Herein, a filling ratio D is used as the evaluation value E.

Herein, as an example, a case is described, where the supply start positions of the first gas for each cycle during the process time T of a substrate processing when the cycle count K is 5 are replaced with points $P_1$ to $P_5$ on a circumference of a circle C, as illustrated in FIG. 6A. In addition, in this example, a case is described where the points $P_1$ to $P_3$ are disposed in an order of $P_1 \rightarrow P_5$ along a circumferential direction, but the order in which the supply start positions are disposed is not limited thereto. For example, the supply start positions may be disposed along the circumferential direction in an order of $P_1 \rightarrow P_4 \rightarrow P_2 \rightarrow P_5 \rightarrow P_3$ depending on a relationship between the cycle time I and the rotational speed N.

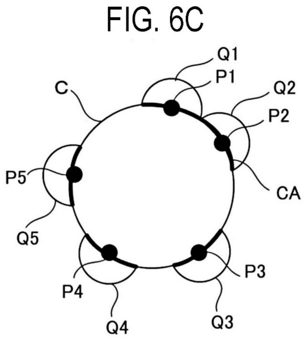

Then, as illustrated in FIG. 6B, circles $Q_1$ to $Q_5$ with the same radius are drawn with the points $P_1$ to $P_5$ defined respectively at centers of circles $Q_1$ to Q5. Then, diameters of the respective circles $Q_1$ to $Q_5$ are increased until any adjacent circles Q come into contact with each other. In this example, the adjacent circles $Q_1$ and $Q_2$ first come into contact with each other. Then, as illustrated in FIG. 6C, an arrangement in which a length of an arc CA, which is a circumferential portion of the circle C that is cut off by the smallest circle Q that first made contact (i.e., a circumferential portion of the circle C overlapping with an inner region of the smallest circle Q), is maximized may be evaluated as an arrangement in which the points $P_1$ to $P_5$ are disposed in the most uniformly spaced and closest manner (in FIG. 6C, the arc CA is represented by a thick line).

Herein, the filling ratio D is defined as a ratio of the arc CA to the circumference of the circle C. That is, the filling ratio D is the ratio of the length of the arc CA, which is a portion on the circumference of the circle C overlapping with the inner region of the smallest circle Q described above, to a circumferential length of the circle C. Then, among a plurality of filling ratios $D(D_1, D_2, ..., D_M)$ calculated respectively for the plurality of rotational speed candidate values $N(N_1, N_2, \cdots, N_M)$ with respect to the predetermined process time T (and/or the predetermined cycle time I) and the predetermined cycle count K, the rotational speed candidate value N that results in an arrangement with a maximum filling ratio D is evaluated as the rotational speed at which the supply start positions are disposed in the most uniformly spaced and closest manner. For example, in a case where the entire supply start positions, i.e., the points $P_1$ to $P_5$, during the process time T are uniformly dispersed and disposed on the circle C, the length of the arc CA coincides with the circumference of the circle C and the filling ratio D becomes 1. Further, in a case where at least two selected from the group of the supply start positions, i.e., the points $P_1$ to $P_5$, during the process time T overlap, a magnitude of the smallest circle Q becomes zero, and thus, the length of the arc CA becomes zero and the filling ratio D becomes zero.

In other words, in a case where the filling ratio $D(D_1, D_2, \cdots, D_M)$ is used as the evaluation value $E(E_1, E_2, ..., E_M)$, the evaluation value $E(E_1, E_2, \cdots, E_M)$ may be defined as a value corresponding to a distance on the circle C between the closest two positions P that may be selected from among the positions $P_1, P_2, \cdots, P_K$ during the process time T for the respective candidate values $N(N_1, N_2, ..., N_M)$. Then, the higher the filling ratio D i.e., the higher the evaluation value E, the more the rotational speed candidate value N may be evaluated as enabling the supply start positions of the process gas to be dispersed without overlapping and be disposed more uniformly and closer to each other. On the other hand, the lower the filling ratio D, i.e., the lower the evaluation value E, the more the rotational speed candidate value N may be evaluated as one that causes overlapping or biased distribution of the supply start positions of the process gas.

Further, levels of priority for being determined as the rotational speed of the wafer 200 are assigned to the plurality of candidate values $N(N_1, N_2, \cdots, N_M)$, according to the order of the respective corresponding evaluation values $E(E_1, E_2, ..., E_M)$. Specifically, levels of priority are assigned to the respective candidate values $N(N_1, N_2, ..., N_M)$ such that the higher the filling ratio D as the evaluation value E, the higher the level of priority for being determined as the rotational speed of the wafer 200.

In addition, in a case where a plurality of candidate values N with the same evaluation value E exist, the same level of priority may be assigned to the respective candidate values N, or different levels of priority may be assigned to some of these candidate values N based on other conditions. For example, a higher level of priority may be assigned to the candidate value N with a smaller rotational speed, among the plurality of candidate values N with the same evaluation value E. Further, for example, a higher level of priority may be assigned to the candidate value N in which the position $P_k$ in the $k^{th}$ intermittent supply and the position $P_{k+1}$ in the $(k+1)^{th}$ intermittent supply are not adjacent to each other on the circumference of the circle C, among the plurality of candidate values N with the same evaluation value E. Further, for example, a higher level of priority may be assigned to the candidate value N in which the position $P_k$ in the $k^{th}$ intermittent supply and the position $P_{k+1}$ in the $(k+1)^{th}$ intermittent supply are spaced farther apart from each other on the circumference of the circle C, among the plurality of candidate values N with the same evaluation value E.

Then, the candidate value N that is assigned the highest level of priority, among the plurality of candidate values $N(N_1, N_2, \cdots, N_M)$, is determined as the rotational speed of the wafer 200. That is, the rotational speed is determined based on the level of priority of the candidate value N. In addition, without being limited to a case where the candidate value N that is assigned the highest level of priority is determined as the rotational speed of the wafer 200, for example, any candidate value N, other than the candidate value N that is assigned the highest level of priority, among a plurality of candidate values N that are assigned levels of priority equal to or higher than a certain value, may be determined as the rotational speed of the wafer 200 by taking other conditions into consideration. Further, in a case where the filling ratio D is used as the evaluation value E, the candidate value N with the largest filling ratio D may be determined as the rotational speed of the wafer 200, without assigning a level of priority.

In addition, in the above description, the arrangement of the positions $P_1$ to $P_K$ with the maximum filling ratio D may also be expressed as a minimax arrangement on a spherical surface as follows.

[Equation 2]

$$\operatorname*{argmax}_{\{P_1,\cdots,P_K\}\in\Pi_K}\ \min_{1\le i<j\le K}\left|P_i-P_j\right|$$

$\Pi_K$ is a set of point arrangements (with K elements), and |Pi - Pj| is a spherical distance between Pi and Pj.

That is, in the above-described equation, the spherical distance between a point $P_i$ and a point $P_j$, which are defined as positions on a spherical surface, is calculated, and an arrangement in which the minimum value of the spherical distance between the point $P_i$ and the point $P_j$ becomes the maximum is calculated. In other words, by the above-described equations 1 and 2, an arrangement in which the minimum value of the spherical distance between the point $P_i$ and point $P_j$ becomes the maximum among the plurality of candidate values $N(N_1, N_2, ..., N_M)$ is calculated based on: at least one selected from the group of the process time T and the cycle time I; the cycle count K; and the respective candidate values N.

FIGS. 7A to 7D are diagrams illustrating an example of calculation results of the filling ratio D for the rotational speed candidate values $N(N_1, N_2, \cdots, N_{60})$ when the above-described minimax arrangement method is applied. In FIGS. 7A to 7D, the process time is set to 171 seconds, the cycle count is set to 40, the rotational speed is set to 0.1 to 6.0 rpm, and the increment is set to 0.1 rpm. The candidate count M for the candidate values N of the settable rotational speed is set to 60 based on the lower and upper limit values of the rotational speed and the increment. In FIG. 7A, the horizontal axis represents the rotational speed [rpm] of the rotator 267, and the vertical axis represents the filling ratio D. Further, each point plotted in FIG. 7A represents the value of the filling ratio D for each rotational speed candidate value $N(N_1, N_2, \cdots, N_{60})$.

FIG. 7B is a diagram illustrating an angular distribution at the supply start of the first gas for each cycle when the rotational speed is 0.2 rpm, and in this case, the filling ratio D is 0.4. FIG. 7C is a diagram illustrating an angular distribution at the supply start of the first gas for each cycle when the rotational speed is 4 rpm, and in this case, the filling ratio D is 0. FIG. 7D is a diagram illustrating an angular distribution at the supply start of the first gas for each cycle when the rotational speed is 4.5 rpm, and in this case, the filling ratio D is 1. In addition, in each of FIGS. 7B to 7D, the number of supply start positions represented by the angular distribution at the start of supply is the same as the cycle count K, i.e., 40.

As illustrated in FIG. 7B, when the filling ratio D is 0.4, the angular distribution at the start of supply is biased. Further, as illustrated in FIG. 7C, when the filling ratio D is 0, the angular distribution at the start of supply overlaps. Further, as illustrated in FIG. 7D, when the filling ratio D is 1, the angular distribution at the start of supply is dispersed without overlapping, and is thus uniformly disposed. That is, when selecting the rotational speeds of 0.5 rpm, 1.5 rpm, 3.5 rpm, 4.5 rpm, and 5.5 rpm from among the rotational speed candidate values $N(N_1, N_2, \cdots, N_{60})$ in which the filling ratio D as the evaluation value E becomes the highest value (i.e., 1), the entire supply start positions are uniformly dispersed and disposed, which may improve the in-plane uniformity of films formed on the wafer 200. In addition, in a case where the evaluation values E corresponding to the plurality of candidate values N(0.5 rpm, 1.5 rpm, 3.5 rpm, 4.5 rpm, and 5.5 rpm) are the same, it is desirable to further select and determine, from among them, a rotational speed suitable for a substrate processing condition as the rotational speed of the wafer 200.

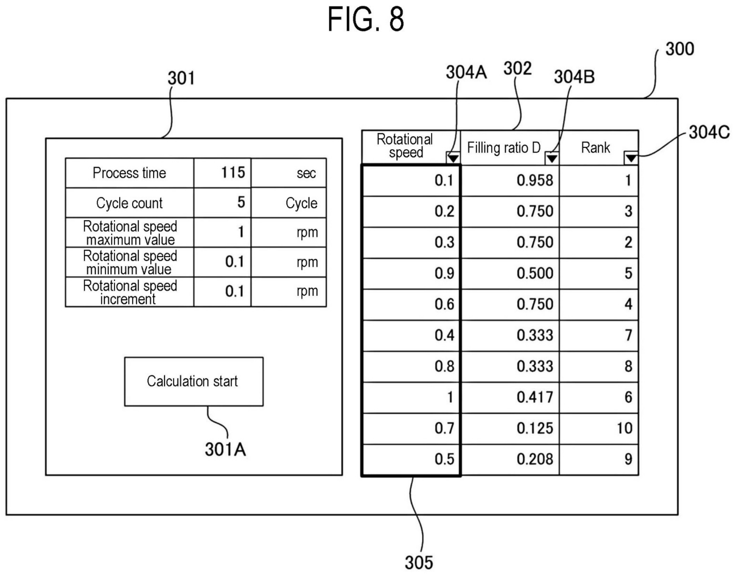

FIG. 8 illustrates an example of a display screen 300 of the input/output device 122 when determining the rotational speed.

The display screen 300 includes an input screen 301 for the operator to input predetermined conditions via the input/output device 122, and an output screen 302 for outputting calculation results based on values input to the input screen 301.

The input screen 301 displays the process time T, the cycle count K, the maximum value $N_{max}$ of the rotational speed, the minimum value $N_{min}$ of the rotational speed, and the increment $N_{int}$ of the rotational speed in an inputtable manner. In addition, instead of the process time T, the cycle time I, which is the time per cycle, may be displayed in an inputtable manner. Further, the input screen 301 is provided with a calculation start button 301A for instructing start of calculation based on input information. When the calculation start button 301A is pressed, calculation processing of the evaluation value E (the filling ratio D in the present embodiments) and the like based on information input to the input screen 301 is executed. In addition, information related to a substrate processing condition such as the process time T, the cycle count K, the cycle time I, and the like may be acquired by referring to the process recipe stored in the memory 121c.

The output screen 302 displays calculation results calculated based on the information input to the input screen 301 such as the process time T, the cycle count K, the maximum value $N_{max}$ of the rotational speed, the minimum value $N_{min}$ of the rotational speed, the increment $N_{int}$ of the rotational speed, the cycle time I, and the like. That is, two or more of a plurality of candidate values N are displayed on the output screen 302 together with the filling ratio D as the evaluation value E corresponding to each of the candidate values. Specifically, the filling ratio D calculated for each rotational speed and the level of priority to be determined as the rotational speed based on the filling ratio D are displayed in ranked order from the highest filling ratio D. Also, the rank may be assigned by further taking into account a substrate processing condition, such as a process gas supply condition and the like, in addition to the filling ratio D (evaluation value E). Further, in the present embodiments, the entire candidate values N and their corresponding filling ratios D and ranks are displayed on the output screen 302, but the display mode is not limited thereto, and the candidate values N with ranks equal to or higher than a predetermined rank (for example, top five) and their corresponding filling ratios D and ranks may be selectively displayed.

Then, among a plurality of rotational speeds displayed on the output screen 302, the candidate value N with the highest level of priority (also referred to as the rank) is determined as the rotational speed of the wafer 200. In addition, the embodiments are not limited to selecting and determining the candidate value N with the highest level of priority as the rotational speed as it is, and the operator may select and determine the rotational speed of the wafer 200 via a selector 305 to be described later, from among the plurality of candidate values N displayed on the output screen 302 based on information displayed on the output screen 302.

Further, respective items on the output screen 302, such as the rotational speed, the filling ratio D, the rank, and the like, are provided with sort sections 304A to 304C for pressing by the operator. When the operator presses the sort section 304A, the plurality of rotational speeds displayed on the output screen 302 may be rearranged and displayed in ascending or descending order thereof. Further, when the operator presses the sort section 304B, the plurality of filling ratios D displayed on the output screen 302 may be rearranged and displayed in descending order thereof. Further, when the operator presses the sort section 304C, the levels of priority to be determined as the rotational speed among the plurality of rotational speeds displayed on the output screen 302 may be rearranged and displayed in descending order thereof.

Further, the rotational speed column in the output screen 302 constitutes the selector 305 that allows one rotational speed to be selected from among the plurality of candidate values N displayed. When one rotational speed is selected and determined by the operator via the selector 305, the substrate processing controller 401 is configured to be able to control the rotator 267 based on the rotational speed selected in the selector 305.

[Another Embodiment of Present Disclosure]

In addition, although an example in which the filling ratio D based on the concept of the minimax arrangement is used as the evaluation value E for determining the rotational speed is described in the above-described embodiments, a potential energy based on a concept of a minimum energy arrangement may be used as the evaluation value E.

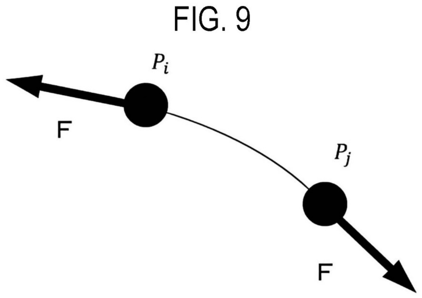

FIG. 9 is a diagram illustrating a minimum energy arrangement method in which a potential energy is used as the above-described evaluation value E.

In the present embodiment, the supply start positions of the first gas for each cycle during the process time T of a substrate processing are replaced with points $P_i$ and $P_j$ on the circle C, as illustrated in FIG. 9, and it is assumed that a repulsive force F is generated between the point $P_i$ and the point $P_j$ such that the closer the points $P_i$ and $P_j$ are to each other, the greater the repulsive force becomes. In this case, a potential energy between the point $P_i$ and the point $P_j$ increases as the points $P_i$ and $P_j$ approach each other, and decreases as the points $P_i$ and $P_j$ are farther apart from each other.

Similarly, a total sum of potential energy associated with the repulsive force F generated mutually between the supply start positions $P_1, P_2, \cdots, P_k, ..., P_K$ decreases as the respective points become farther apart. For example, if the entire supply start positions during the process time T are uniformly dispersed and disposed on the circle C, the total sum of potential energy defined between the entire supply start positions becomes low. Further, if there is overlap or bias among the supply start positions during the process time T, the total sum of potential energy defined between the entire supply start positions becomes high.

Accordingly, in the present embodiment, the total sum of potential energy $G(G_1, G_2, ..., G_M)$ defined between the positions $P_1, P_2, ..., P_K$ during the process time T, or a value corresponding thereto is used as the evaluation value $E(E_1, E_2, \cdots, E_M)$. Then, the total sum of potential energy $G(G_1, G_2, ..., G_M)$, which becomes the evaluation value $E(E_1, E_2, ..., E_M)$ corresponding respectively to the plurality of candidate values $N(N_1, N_2, ..., N_M)$, is calculated based on: at least one selected from the group of the process time T and the cycle time I; the cycle count K; and the respective candidate values N.

Then, the rotational speed to be applied in the substrate processing is determined from among the plurality of candidate values N based on the calculated total sum of potential energy G.

Further, levels of priority to be determined as the rotational speed of the wafer 200 are assigned according to the order of values of the total sum of potential energy $G(G_1, G_2, ..., G_M)$ corresponding respectively to the plurality of candidate values N (or values of the evaluation value $E(E_1, E_2, ..., E_M)$ corresponding to the total sum of potential energy G). Specifically, the levels of priority to be determined as the rotational speed are ranked from the lowest to the highest total sum of potential energy G. Then, the rotational speed that is assigned a highest level of priority is determined as the rotational speed of the wafer 200. Further, the evaluation value E may be set to a higher value as the total sum of potential energy G becomes smaller, and to a lower value as the total sum of potential energy G becomes larger. In that case, the levels of priority are ranked from the highest to the lowest evaluation value E.

FIGS. 10A to 10D are diagrams illustrating calculation results of the total sum of potential energy G with respect to the rotational speed candidate values $N(N_1, N_2, ..., N_{60})$ when the above-described minimum energy arrangement method is applied to the present embodiment. In FIGS. 10A to 10D, the process time is set to 171 seconds, the cycle count is set to 40, the rotational speed is set to 0.1 to 6.0 rpm, and the increment is set to 0.1 rpm. The candidate count M is set to 60, similarly to FIGS. 7A to 7D. In FIG. 10A, the horizontal axis represents the rotational speed [rpm] of the rotator 267, and the vertical axis represents the total sum of potential energy G. Further, each point plotted in FIG. 10A represents the value of the total sum of potential energy G with respect to the respective rotational speed candidate values $N(N_1, N_2, \cdots, N_{60})$.

FIG. 10B is a diagram illustrating an angular distribution at the supply start of the first gas for each cycle when the rotational speed is 2.5 rpm, and in this case, the total sum of potential energy G is approximately 5,500. FIG. 10C is a diagram illustrating an angular distribution at the supply start of the first gas for each cycle when the rotational speed is 3 rpm, and in this case, the total sum of potential energy G is 2,000. FIG. 10D is a diagram illustrating an angular distribution of the supply start of the first gas for each cycle when the rotational speed is 4.5 rpm, and in this case, the total sum of potential energy G is less than 1,000.

As illustrated in FIG. 10D, when the total sum of potential energy G is smaller than those in FIGS. 10B and 10C, the angular distribution at the supply start of the first gas for each cycle is dispersed without overlapping and is uniformly disposed.

That is, the smaller the total sum of potential energy G as the evaluation value E, the more the supply start positions of the first gas for each cycle are dispersed on the circumference and uniformly disposed. Therefore, the rotational speed is determined by increasing the level of priority of the rotational speed with a small total sum of potential energy G. Thus, the supply start positions are uniformly dispersed and disposed, resulting in an improvement in the in-plane uniformity of films formed on the wafer 200. In other words, the same effects as those in the above-described embodiments are obtained also in the present embodiment.

The embodiments of the present disclosure are specifically described above. However, the present disclosure is not limited to the above-described embodiments, and may be changed in various ways without departing from the gist of the present disclosure.

In the present disclosure, as an example, a case is described, where a candidate value with the highest level of priority, among a plurality of candidate values N, is determined as the rotational speed of the wafer 200, but the present disclosure is not limited thereto. For example, a candidate value N, among a plurality of candidate values N, with the corresponding evaluation value E being within a predetermined range may be determined as the rotational speed of the wafer 200. For example, by setting an upper limit value or a lower limit value (i.e., the predetermined range) such as the filling ratio D of 0.8 or higher or the total sum of potential energy G of less than 1,000, the rotational speed of the wafer 200 may be selected and determined from one or more candidate values N included in such a range. This may prevent a candidate value N that does not satisfy a desired evaluation value E from being determined as the rotational speed. Further, an optimal rotational speed may be easily and efficiently determined regardless of mechanical constraints of the rotator 267.

In the present disclosure, the description is made using, as an example, a case where two types of gases, i.e., the first gas and the second gas, are intermittently supplied, but the present disclosure is not limited thereto, and may also be suitably applied to a case where one type of gas or three or more types of gases are intermittently supplied. The same effects as those in the above-described embodiments are obtained also in this embodiment.

In the present disclosure, the description is made using, as an example, a case where the filling ratio D obtained by applying the minimax arrangement method is displayed as the evaluation value E on the display screen 300 of the input/output device 122 when determining the rotational speed, but the present disclosure is not limited thereto, and the total sum of potential energy G obtained by applying the minimum energy arrangement method may be displayed as the evaluation value E on the output screen 302 of the display screen 300, or both the filling ratio D obtained by applying the minimax arrangement method and the total sum of potential energy G obtained by applying the minimum energy arrangement method may be respectively displayed as the evaluation values E.

The present disclosure may also be suitably applied to a case where a film is formed using a single-wafer-type substrate processing apparatus that processes one or a few substrates at a time. Further, the present disclosure may also be suitably applied in a case where a film is formed using a substrate processing apparatus equipped with a cold-wall-type process furnace. Further, the present disclosure may also be suitably applied, for example, in a case where a gas is activated by plasma generated inside or outside the process chamber 201, or in a case where a gas is activated by irradiating the gas with electromagnetic waves using a lamp or other sources.

Even when using these substrate processing apparatuses, it is possible to perform each processing using the same processing procedures and processing conditions as those in the above-described embodiments, and to achieve the same effects as those in the above-described embodiments.

The above-described embodiments may be used in combination as appropriate. The processing procedures and processing conditions at this time may be the same as those in the above-described embodiments, for example.

According to the present disclosure, it becomes possible to improve in-plane uniformity of processing on a rotating substrate.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.


**Claims**

1. A method of determining a rotational speed of a substrate (200), applied in a substrate processing including intermittently supplying, to the rotating substrate (200), a process gas from an outer edge of the substrate (200) toward an in-plane direction at a constant interval, a predetermined number of times K, during a predetermined duration T, the method comprising:

   (a) calculating an evaluation value E corresponding to each of a plurality of candidate values N, which are a plurality of candidate values for the selectable rotational speed of the substrate (200), based on: at least one selected from the group of the predetermined duration T and a supply interval I of the process gas; the predetermined number of times K; and each of the plurality of candidate values N; and
   (b) determining the rotational speed of the substrate (200) to be applied in the substrate processing from among the plurality of candidate values N based on the evaluation value E calculated for each of the plurality of candidate values N.

2. The method of Claim 1, wherein each of the plurality of candidate values N is a value of the rotational speed that satisfies a condition of a minimum width in which the rotational speed is changeable.

3. The method of Claim 1 or 2, wherein each of the plurality of candidate values N is selected from within a range of values that are equal to or less than an upper limit value of the rotational speed.

4. The method of any one of Claims 1 to 3, wherein each of the plurality of candidate values N is selected from within a range of values that are equal to or greater than a lower limit value of the rotational speed.

5. The method of any one of Claims 1 to 4, wherein in (b), a level of priority to be determined as the rotational speed of the substrate (200) is assigned to the plurality of candidate values N according to an order of the evaluation value E corresponding to each of the plurality of candidate values N.

6. The method of Claim 5, wherein in (b), a candidate value N, among the plurality of candidate values N, that is assigned a highest level of priority is determined as the rotational speed of the substrate (200).

7. The method of any one of Claims 1 to 6, wherein the evaluation value E is a value indicating a degree of uniformity of spacing between positions P along a circumference of the outer edge of the substrate (200) that face a supply port (250a, 250b) of the process gas at a point in time when intermittent supply of the process gas is initiated for each of the predetermined number of times K.

8. The method of Claim 7, wherein each evaluation value E corresponds to a distance between two closest positions P, among the positions P during the predetermined duration T.

9. The method of Claim 7, wherein each evaluation value E corresponds to a total sum of potential energy defined between the positions P during the predetermined duration T.

10. A method of processing a substrate (200), comprising:
    intermittently supplying a process gas to the substrate (200) rotating at a predetermined rotational speed determined by the method of any one of Claims 1 to 9.

11. A method of manufacturing a semiconductor device, comprising the method of Claim 10.

12. A program that causes a computer including a calculator (402) and a display to perform a process comprising:

(a) calculating, by the calculator (402), a corresponding evaluation value E for each of a plurality of candidate values N, which are a plurality of candidate values for a rotational speed of a substrate (200) selectable from among rotational speeds of the substrate (200) applied in a substrate processing of intermittently supplying, to the rotating substrate (200), a process gas from an outer edge of the substrate (200) toward an in-plane direction at a constant interval, a predetermined number of times K, during a predetermined duration T, based on: at least one selected from the group of the predetermined duration T and a supply interval I of the process gas; the predetermined number of times K; and each of the plurality of candidate values N; and

(b) displaying, by the display, two or more candidate values N from the plurality of candidate values N together with the evaluation value E calculated corresponding to each of the two or more candidate values N.

**13.** A substrate processing apparatus comprising:

a rotation driver (267) configured to rotate a substrate (200);

a gas supply system configured to supply, to the substrate (200), a process gas from an outer edge of the substrate (200) toward an in-plane direction;

a substrate processing controller (401) configured to be capable of controlling the rotation driver (267) and the gas supply system, so as to intermittently supply the process gas to the substrate (200) at a constant interval, a predetermined number of times K, during a predetermined duration T while rotating the substrate (200) at a predetermined rotational speed; and

a calculator (402) configured to calculate an evaluation value E corresponding to each of a plurality of candidate values N, which are a plurality of candidate values for a selectable rotational speed of the substrate (200), based on: at least one selected from the group of the predetermined duration T and a supply interval I of the process gas; the predetermined number of times K; and each of the plurality of candidate values N,

wherein the substrate processing controller (401) is configured to be capable of controlling the substrate (200) to rotate at the predetermined rotational speed determined from among the plurality of candidate values N based on the evaluation value E calculated by the calculator (402) for each of the plurality of candidate values N.

**14.** The substrate processing apparatus of Claim 13, further comprising a memory (121b, 121c) capable of storing: at least one selected from the group of the predetermined duration T and the supply interval I of the process gas; the predetermined number of times K; and a minimum width in which the rotational speed is changeable,

wherein the calculator (402) is configured to calculate each of the plurality of candidate values N based on the minimum width stored in the memory (121b, 121c).

**15.** The substrate processing apparatus of Claim 13 or 14, further comprising:

a display configured to display two or more candidate values N from the plurality of candidate values N together with the evaluation value E calculated corresponding to each of the two or more candidate values N; and

a selector (305) configured to allow an operator to select one of the two or more candidate values N displayed on the display as the predetermined rotational speed,

wherein the substrate processing controller (401) is configured to be capable of controlling the rotation driver (267) based on the predetermined rotational speed selected in the selector (305).

# FIG. 1

# FIG. 2

# FIG. 3

# FIG. 4

EP 4 786 636 A1

FIG. 5A

200

FIG. 5B

200

# FIG. 6A

# FIG. 6B

FIG. 6C

# FIG. 7A

FIG. 7B

FIG. 7C

FIG. 7D

# FIG. 8

| Process time | 115 | sec |
|---|---|---|
| Cycle count | 5 | Cycle |
| Rotational speed maximum value | 1 | rpm |
| Rotational speed minimum value | 0.1 | rpm |
| Rotational speed increment | 0.1 | rpm |

Calculation start

301A

| Rotational speed | Filling ratio D | Rank |
|---|---|---|
| 0.1 | 0.958 | 1 |
| 0.2 | 0.750 | 3 |
| 0.3 | 0.750 | 2 |
| 0.9 | 0.500 | 5 |
| 0.6 | 0.750 | 4 |
| 0.4 | 0.333 | 7 |
| 0.8 | 0.333 | 8 |
| 1 | 0.417 | 6 |
| 0.7 | 0.125 | 10 |
| 0.5 | 0.208 | 9 |

FIG. 9

## FIG. 10A

FIG. 10B

FIG. 10C

FIG. 10D

**Europäisches Patentamt**
**European Patent Office**
**Office européen des brevets**

# EUROPEAN SEARCH REPORT

Application Number

EP 26 15 3718

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2012/315394 A1 (ITO SHOZO [JP]) 13 December 2012 (2012-12-13) * paragraph [0118] - paragraph [0137] * * figures 3, 8 * | 1-15 | INV. C23C16/455 C23C16/458 C23C16/52 |
| A | US 2017/287716 A1 (KAGA YUKINAO [JP]) 5 October 2017 (2017-10-05) * paragraph [0075] - paragraph [0079] * * figures 5A, 5B, 6A, 6B * | 1-15 | |
| A | US 2011/287172 A1 (MATSUDA KAZUHISA [JP]) 24 November 2011 (2011-11-24) * paragraph [0052] - paragraph [0063] * * figures 2-6 * | 1-15 | |
| A | JP 2011 216906 A (HITACHI INT ELECTRIC INC) 27 October 2011 (2011-10-27) * paragraph [0051] - paragraph [0054] * * figure 4 * | 1-15 | |
| | | | **TECHNICAL FIELDS SEARCHED (IPC)** C23C |

The present search report has been drawn up for all claims

| Place of search | Date of completion of the search | Examiner |
|---|---|---|
| The Hague | 12 June 2026 | Fertig, Andrea |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 26 15 3718

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2026

| Patent document cited in search report | Publication date | Patent family member(s) | Publication date |
|---|---|---|---|
| US 2012315394 A1 | 13-12-2012 | CN 102804346 A<br>JP 5742185 B2<br>JP 2011216844 A<br>KR 20130014496 A<br>TW 201218295 A<br>US 2012315394 A1<br>WO 2011115250 A1 | 28-11-2012<br>01-07-2015<br>27-10-2011<br>07-02-2013<br>01-05-2012<br>13-12-2012<br>22-09-2011 |
| US 2017287716 A1 | 05-10-2017 | JP WO2016098183 A1<br>US 2017287716 A1<br>WO 2016098183 A1 | 10-08-2017<br>05-10-2017<br>23-06-2016 |
| US 2011287172 A1 | 24-11-2011 | CN 102251226 A<br>JP 5872141 B2<br>JP 2011241460 A<br>KR 20110128144 A<br>TW 201203427 A<br>US 2011287172 A1 | 23-11-2011<br>01-03-2016<br>01-12-2011<br>28-11-2011<br>16-01-2012<br>24-11-2011 |
| JP 2011216906 A | 27-10-2011 | JP 5362782 B2<br>JP 2011216906 A | 11-12-2013<br>27-10-2011 |

For more details about this annex : see Official Journal of the European Patent Office, No. 12/82

**REFERENCES CITED IN THE DESCRIPTION**

**Patent documents cited in the description**

- JP 2025013309 A